(19) Europäisches Patentamt
European Patent Office
Office européen des brevets

(11) **EP 3 236 720 A1**

(12) **EUROPEAN PATENT APPLICATION**
published in accordance with Art. 153(4) EPC

(43) Date of publication:
**25.10.2017 Bulletin 2017/43**

(51) Int Cl.:
**H05K 3/42** *(2006.01)*   **H05K 1/03** *(2006.01)*

(21) Application number: **15862810.7**

(86) International application number:
**PCT/JP2015/005867**

(22) Date of filing: **26.11.2015**

(87) International publication number:
**WO 2016/084374 (02.06.2016 Gazette 2016/22)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **28.11.2014 JP 2014241922**

(71) Applicant: **Zeon Corporation**
**Tokyo 100-8246 (JP)**

(72) Inventors:
• **FUJIMURA, Makoto**
**Tokyo 100-8246 (JP)**
• **IGA, Takashi**
**Tokyo 100-8246 (JP)**

(74) Representative: **Viering, Jentschura & Partner mbB**
**Patent- und Rechtsanwälte**
**Am Brauhaus 8**
**01099 Dresden (DE)**

(54) **DESMEAR PROCESSING METHOD AND MANUFACTURING METHOD FOR MULTILAYER PRINTED WIRING BOARD**

(57)    The purpose of the present invention is to provide a desmear processing method capable of sufficiently removing a smear while preventing the surface of a substrate from being rough. The desmear processing method according to the present invention is a desmear processing method for removing smear from a substrate in which a hole is formed, the desmear processing method comprising a first desmear processing step for dissolving and decomposing a part of the smear, and a second desmear processing step for performing ultrasonic treatment on the substrate after the first desmear processing step. Further, in the second desmear processing step, at least one of: changing the frequency of the ultrasonic waves; and moving an oscillation source of the ultrasonic waves and the substrate in two or more directions relatively to each other, is performed during the ultrasonic treating.

*FIG. 1*

(a)

Desmear processing time

(b)

Desmear processing time

## Description

TECHNICAL FIELD

The present invention relates to a desmear processing method and a manufacturing method for a multilayer printed wiring board, more particularly to a desmear processing method for removal of residual substances (smear) of substrate materials from a substrate, and a manufacturing method for a multilayer printed wiring board using the desmear processing method.

BACKGROUND ART

Printed wiring boards conventionally used for the manufacture of electronic devices may include multilayer printed wiring boards. The multilayer printed wiring board has electrical insulating layers and conductor layers (wiring layers) that are alternately stacked on a substrate. Typically, the multilayer printed wiring board may further have vias (for example, blind vias, buried vias, through-hole vias) that are formed to electrically interconnect the conductor layers spaced apart in a layer-stacking direction.

The multilayer printed wiring board having such vias may be obtained as follows. First, an inner substrate is prepared that has an electrical insulating layer and a conductor layer formed on the electrical insulating layer. Then, the following steps are repeatedly performed; stacking an electrical insulating layer on the inner substrate, forming holes for the vias in the electrical insulating layer by laser machining or drilling, removing smear (desmearing), for example, any residual resin generated during the formation of the holes, forming a conductor layer on a surface of the electrical insulating layer where the holes have been formed, and forming conductors in the holes to interconnect the conductor layers (formation of vias).

In the manufacture of the multilayer printed wiring board, desmear processing methods may be employed to remove the smear from the substrate after the holes are formed therein. Some of the methods may dissolve or decompose the smear using a desmear solution, for example, a potassium permanganate-containing solution, ultraviolet light, or plasma. There are other desmear processing methods that have recently been published, which may further include ultrasonic treatment after the processing using desmear solution or ultraviolet, in an attempt to more efficiently remove the smear (for example, Patent Literature 1 and 2).

CITATIONS LIST

Patent Literature

   Patent Literature 1: Japanese Unexamined Patent Application Publication No. 2005-327978
   Patent Literature 2: WO 2014/104154

SUMMARY OF THE INVENTION

Technical Problems

Miniaturization, multifunctionality, and high-speed communication increasingly demanded in electronic devices have introduced the need for more sophisticated multilayer printed wiring boards. In the meantime, the conventional desmear processing methods still leave room for improvements for a better desmearing effect and thorough removal of the smear. In high-performance multilayer printed wiring boards, electrical insulating layers made from low loss tangent materials may be used to effectively suppress the transmission loss of electrical signals. Yet, smear generated from low loss tangent materials may be particularly difficult to remove. Thus, improvements of the desmearing effect are seriously demanded in the manufacture of such multilayer printed wiring boards.

The inventors of this application engaged in various studies to achieve an improved desmearing effect and discovered that, while extending the ultrasonic treatment time alone may be not enough to improve the desmearing effect, an improved desmearing effect may be obtainable when the desmear processing time using desmear solution, ultraviolet, or plasma is lengthened.

However, further studies revealed that the process to dissolve or decompose smear using the desmear solution, ultraviolet, or plasma, if carried on over an extended time, may roughen the substrate's target surface. A multilayer printed wiring board with conductor layers formed on such a surface-roughened substrate may undergo major conductor loss, failing to adequately suppress the transmission loss of electrical signals (i.e., failure to obtain a high-performance printed wiring board).

To address these issues, the present invention provides a desmear processing method that may thoroughly remove generated smear, while substantially preventing a substrate's target surface from being roughened.

The present invention further provides a manufacturing method for a multilayer printed wiring board that may thoroughly remove generated smear and successfully manufacture a high-performance multilayer printed wiring board.

SOLUTIONS TO THE PROBLEMS

To this end, the inventors of this application conducted extensive studies and discussed various options. Subsequently, the inventors accomplished the present invention based on their finding that ultrasonic treatment performed under predetermined conditions subsequent to the dissolution or decomposition of smear may succeed in thorough removal of the smear, while substantially preventing a substrate's target surface from being roughened.

To address the issues of the known art, the present invention provides a desmear processing method for removing smear from a substrate having holes formed therein, including a first desmear processing step of dissolving or decomposing part of the smear, and a second desmear processing step of subjecting the substrate to an ultrasonic treatment subsequent to the first desmear processing step. The second desmear processing step includes, during the ultrasonic treatment, at least one of: changing an ultrasonic frequency; and moving the substrate and an ultrasonic oscillation source relative to each other in two or more directions. In the first desmear processing step of this method, the smear is only partly removed. This may substantially prevent the substrate's target surface from being roughened. In the second desmear processing step subsequent to the first desmear processing step, the substrate is subjected to the ultrasonic treatment under predetermined conditions to thoroughly remove the smear. These steps thus performed may achieve thorough removal of the smear, achieving an improved desmearing effect.

In the desmear processing method according to the present invention, ultrasonic waves radiated during the ultrasonic treatment preferably have a frequency more than or equal to 15 kHz and less than or equal to 200 kHz. An ultrasonic frequency between 15 kHz and 200 kHz may lead to a further improved desmearing effect.

In the desmear processing method according to the present invention, a distance D of the relative movement of the substrate and the ultrasonic oscillation source satisfies the relational expression: $\{\text{sonic speed}/(\text{ultrasonic frequency} \times 2)\}/4 \leq D \leq 150 \times \{\text{sonic speed}/(\text{ultrasonic frequency} \times 2)\}$. A relative movement of the substrate and the ultrasonic oscillation source that satisfies this relational expression may be easier to perform and allow improvements of the desmearing effect.

In the present invention, "sonic speed" means the sonic speed under conditions employed to irradiate the substrate with ultrasonic waves. When the substrate is irradiated with ultrasonic waves in water, for example, "sonic speed" means a sonic speed in water. When the ultrasonic oscillation source and the substrate are moved relative to each other in two or more directions, a distance of the relative movement of the substrate and the ultrasonic oscillation source in one or more directions may satisfy the foregoing relational expression.

In the first desmear processing step of the desmear processing method according to the present invention, the smear is preferably dissolved or decomposed by at least one means selected from the group consisting of a desmear solution, plasma, and light. This is because easy and efficient removal of the smear may certainly be possible by using at least one of a desmear solution, plasma, and light. In the first desmear processing step, a permanganate-containing desmear solution is more preferably used to dissolve or decompose the smear. This is because the permanganate-containing desmear solution may allow low-cost and efficient removal of the smear.

In the desmear processing method according to the present invention, preferably the substrate is an electrical insulating layer having the holes, and the electrical insulating layer includes a cured material having a loss tangent less than or equal to 0.005 at the frequency of 5 GHz. This is because using a cured material having a loss tangent of 0.005 or less at the frequency of 5 GHz to form the electrical insulating layer may serve the purpose of manufacturing a high-performance multilayer printed wiring board in which the transmission loss of electrical signals is controllable. Conventionally, smear generated from low loss tangent materials may be very difficult to remove. Yet, the desmear processing method according to the present invention may thoroughly remove the smear of a cured material having a loss tangent of 0.005 or less generated during the formation of the holes in the electrical insulating layer.

The "loss tangent at the frequency of 5 GHz" described in the present invention may be measured by a cavity resonator perturbation technique.

In the substrate subjected to the desmear processing method according to the present invention, a curable resin composition containing an epoxy resin and an activated ester compound is preferably used to form the electrical insulating layer having the holes. The curable resin composition used to form the electrical insulating layer more preferably further contains a polyphenylene ether compound.

Further, the electrical insulating layer preferably includes a layer containing 50% or more by mass of an inorganic filler.

In the desmear processing method according to the present invention, preferably the substrate has a support and an electrical insulating layer having the holes, and the support is formed on a surface of the electrical insulating layer to be a part of the surface. This is because the substrate thus provided with the support may prevent the surface of the electrical insulating layer from being roughened by the desmearing during the first desmear processing step.

The support further preferably has ultraviolet absorptivity. This is because a support having ultraviolet absorptivity may facilitate the formation of holes using means such as an excimer laser, UV laser, or UV-YAG laser. The "ultraviolet absorptivity" described in the present invention means a light transmittance of 20% or less when measured by a UV-visible absorptiometer at the wavelength of 355 nm.

To address the issues of the known art, the present invention further provides a manufacturing method for a multilayer printed wiring board, in particular, a multilayer printed wiring board having vias. The manufacturing method includes steps of: forming holes for vias in a substrate having electrical insulating layers and conductor layers that are alternately stacked; and removing smear generated during the formation of the holes using the desmear processing method according to any one of the aspects described earlier. The desmear processing method described thus far may thoroughly remove the smear, while substantially preventing a substrate's target surface from being roughened. As a result, a high-performance multilayer printed wiring board may be successfully obtained.

EFFECTS OF THE INVENTION

The present invention provides a desmear processing method that may thoroughly remove smear, while substantially preventing a substrate's target surface from being roughened. The present invention further provides a manufacturing method for a multilayer printed wiring board that may thoroughly remove any smear from a substrate and successfully manufacture a high-performance multilayer printed wiring board.

BRIEF DESCRIPTION OF THE DRAWINGS

FIGS. 1A and 1B are diagrams illustrating desmear processing time - frequency relationships when the frequency of ultrasonic waves are changed during an ultrasonic treatment in a second desmear processing step; FIG. 1A shows a relationship when the ultrasonic frequency is changed in stages; and FIG. 1B shows a relationship when the ultrasonic frequency is changed in succession.
FIG. 2 is a drawing provided to describe directions of movement of a substrate during the ultrasonic treatment in the second desmear processing step.

DESCRIPTION OF EMBODIMENTS

Embodiments of the present invention are hereinafter described in detail. A desmear processing method according to the present invention may be used to remove smear generated during the formation of holes in a substrate having a layered structure of electrical insulating layers and conductor layers that are alternately stacked. The desmear processing method may be suitable for the manufacture of a multilayer printed wiring board having vias using a manufacturing method for a multilayer printed wiring board according to the present invention.

Manufacturing method for multilayer printed wiring board

A manufacturing method for a multilayer printed wiring board according to the present invention may be used to manufacture a multilayer printed wiring board having electrical insulating layers and conductor layers that are alternately stacked on a substrate and vias formed to electrically interconnect the conductor layers spaced apart in a layer-stacking direction.

An example of the manufacturing method for a multilayer printed wiring board according to the present invention starts with preparing an inner substrate that has an electrical insulating layer and a conductor layer formed on the electrical insulating layer, and then repeatedly forms an electrical insulating layer(s) on the inner substrate and a conductor layer(s) on the electrical insulating layer(s) to manufacture a multilayer printed wiring board having a desired number of electrical insulating layers and conductor layers that are alternately stacked. An example of the manufacturing method for a multilayer printed wiring board according to the present invention performs at least once a via forming step including forming holes for vias, removing smear generated during the formation of the holes, and forming conductors in the holes to provide a multilayer printed wiring board with vias, e.g. blind vias, buried vias, or through hole vias. The manufacturing method for a multilayer printed wiring board according to the present invention may employ the desmear processing method according to the present invention, which will be described later in detail, to remove the smear during the via forming step.

Base substrate

The base substrate, on which the electrical insulating layer and the conductor layer will be stacked, may be any suitable one selected from the known substrates conventionally used in the manufacture of multilayer printed wiring boards. Specific examples of the base substrate may include electrical insulating substrates, printed wiring boards, and printed circuit boards. The electrical insulating substrate may be obtained by curing a resin composition containing an electrical insulating material selected from, for example, alicyclic olefin polymers, epoxy compounds, maleimide resins, acrylic resins, methacrylate resins, diallyl phthalate resins, triazine resins, polyphenylene ether resins, polyimide resins, wholly aromatic polyester resins, and glass.

Formation of electrical insulating layer

The electrical insulating layer may be a layer including a cured material obtained by curing a curable resin composition (insulating resin layer). A specific example of the electrical insulating layer may be a monolayered or multilayered insulating resin layer obtained by curing a single layer or multiple layers of a curable resin composition.
The electrical insulating layer may have a loss tangent less than or equal to 0.005 at the frequency of 5 GHz to desirably obtain a high-performance multilayer printed wiring board that can effectively suppress the transmission loss of electrical signals. The loss tangent of a cured material may be adjustable by modifying constituents of the curable resin composition. For example, polar groups of a resin contained in the curable resin composition may be decreased to reduce the loss tangent of the cured material.
Methods for forming the electrical insulating layer on the inner substrate or on a layered structure of the electrical insulating layer and the conductor layer alternately formed on the inner substrate may include, but are not limited to, steps of forming a curable resin composition layer on the support, disposing the support-attached curable resin composition layer on the layered structure so that the curable resin composition layer faces the layered structure, and then curing the curable resin composition layer on the layered structure by, for example, heating. At an optional point in time after the support-attached curable resin composition layer is disposed on the layered structure, the support may be deatched from the curable resin composition layer. When the via holes need to be formed in the electrical insulating layer, the support is preferably removed at any point in time suitable for smear removing methods employed after the via holes are formed. When plasma or light is used in the first desmear processing step described later, the support is preferably removed at an optional point in time after the first desmear processing step. When the desmear solution is used in the first desmear processing step, the support may be removed prior to the first desmear processing step. When plasma or light is used in the first desmear processing step, the support may be detached after the via holes are formed and the smear is removed so as to prevent the desmearing from roughening the surface of the electrical insulating layer. In other words, the support is usable as a protective film for the electrical insulating layer during the desmearing.
Non-limiting examples of the support may include a plate-like member and a filmy member. Specific examples of the support may include films or plates made from polymer compounds such as polyethylene terephthalate, polypropylene, polyethylene, polycarbonate, polyethylene naphthalate, polyarylate, nylon, and polytetrafluoroethylene, and glass substrates. Among these examples, the support is preferably a polyethylene terephthalate film.
In order to readily detach the support, the support's surface may be subjected to a suitable release treatment, for example, may be coated with a release layer. When the via holes are formed by laser machining before the support is detached, the support preferably has ultraviolet absorptivity This is because the support having ultraviolet absorptivity may facilitate the laser machining using such a means as an excimer laser, UV laser, or UV-YAG laser. Another advantage of using the support having ultraviolet absorptivity is that ultraviolet light, when used to remove the smear, may be absorbed by the support. This may substantially prevent the surface of the electrical insulating layer from being roughened by the desmearing.
Examples of the curable resin composition used to form the curable resin composition layer may include, but are not limited to, the known thermosetting resin compositions conventionally used in the manufacture of multilayer printed wiring boards. A specific example of the curable resin composition may be a curable resin composition containing a curable resin and a curing agent, and optionally further containing a filler and/or a polyphenylene ether compound.
The curable resin may be selected from any resins curable when combined with a curing agent and having electrical insulating properties, for example, epoxy resins, maleimide resins, acrylic resins, methacrylate resins, diallyl phthalate resins, triazine resins, alicyclic olefin polymers, aromatic polyether polymers, benzocyclobutene polymers, cyanate ester polymers, and polyimide. Among these examples, the curable resin is preferably selected from epoxy resins and polar group-containing alicyclic olefin polymers. Any one of these examples may be singly used, or two or more of them may be combined and used. As the epoxy resin, multivalent epoxy compounds having a biphenyl structure and/or a fused polycyclic structure are preferable. A mixture of a multivalent epoxy compound having a biphenyl structure and/or a fused polycyclic structure, a trivalent or higher, multivalent glycidyl group-containing epoxy compound (except compounds equivalent to multivalent epoxy compounds having a biphenyl structure and/or a fused polycyclic structure), and a phenol resin having a triazine structure is more preferable. As the polar group-containing alicyclic olefin polymer, polymers having a cycloalkane structure and having, as a polar group, at least one functional group selected from the group consisting of alcoholic hydroxyl group, phenolic hydroxyl group, carboxyl group, alkoxyl group, epoxy group, glycidyl group, oxycarbonyl group, carbonyl group, amino group, carboxylic acid anhydride group, sulfonic group, and phosphate group are preferable.

To form an electrical insulating layer including multiple insulating resin layers by curing multiple curable resin composition layers formed on the support, preferably a curable resin composition layer made from a curable resin composition containing, as a curable resin, a polar group-containing alicyclic olefin polymer may be formed on a support-located side, and a curable resin composition layer made from a curable resin composition containing, as a curable resin, an epoxy resin is formed on the other side opposite to the support (layered structure-located side). Thus, the curable resin composition layer on the support-located side, which is made from a curable resin composition containing, as a curable resin, a polar group-containing alicyclic olefin polymer, may improve adhesion of the electric insulating layer to the conductor layer formed thereon.

The curing agent may be selected from the known compounds that can react with a curable resin when heated to cure the curable resin composition. When the curable resin is an epoxy resin, for example, examples of the curing agent may include, but are not limited, to activated ester compounds, and preferably activated ester compounds having at least two active ester groups in a molecule. When the curable resin is a polar group-containing alicyclic olefin polymer, for example, the curing agent may be, but is not limited to, a compound having two or more functional groups that can form a bond through reactions with the polar group of the polar group-containing alicyclic olefin polymer. The activated ester compound is preferably an activated ester compound obtainable by reacting a carboxylic acid compound and/or a thiocarboxylic acid compound with a hydroxy compound and/or a thiol compound. The activated ester compound is preferably an activated ester compound obtainable by reacting one or two or more selected from the group consisting of carboxylic acid compounds, phenol compounds, naphthol compounds, and thiol compounds, and is more preferably an aromatic compound obtainable obtainable by reacting a carboxylic acid compound with a phenolic hydroxyl group-containing aromatic compound and having at least two active ester groups in a molecule. Examples of the compound having two or more functional groups that can form a bond through reactions with the polar group may include multivalent epoxy compounds, multivalent isocyanate compounds, multivalent amine compounds, multivalent hidrazide compounds, aziridine compounds, basic metallic oxides, and organometallic halides. Any one of these examples may be singly used, or two or more of them may be combined and used. One selected from these compounds and a peroxide may be combined and used as a curing agent.

The filler may be selected from the known inorganic and organic fillers by which the coefficient of linear expansion of the electrical insulating layer can be suppressed. The filler is preferably selected from the inorganic fillers. Specific examples of the inorganic filler may include calcium carbonate, magnesium carbonate, barium carbonate, zinc oxide, titanium oxide, magnesium oxide, magnesium silicate, calcium silicate, zirconium silicate, hydrated alumina, magnesium hydroxide, aluminum hydroxide, barium sulfate, silica, talc, and clay. The filler to be used may be subjected to a surface treatment beforehand using, for example, a silane coupling agent. The content of the filler in the curable resin composition may be 50% or more by mass in terms of a solid content. To form the electrical insulating layer including multiple insulating resin layers by curing multiple curable resin composition layers, a curable resin composition containing 50% or more by mass of the filler in terms of a solid content is preferably used to form at least one of the multiple curable resin composition layers.

The curable resin composition, in addition to the constituents mentioned earlier, may further contain a polyphenylene ether compound. The curable resin composition further containing a polyphenylene ether compound may allow the electrical insulating layer obtained from this composition to have a higher heat resistance and a lower loss tangent. The curable resin composition may further contain a known compounding agent, for example, curing accelerator, fire retardant, fire-retarding assistant, heat resistance stabilizer, weather resistance stabilizer, antioxidant, ultraviolet absorbent (laser machining improver), levelling agent, antistatic agent, slip agent, anti-blocking agent, anti-fogging agent, lubricant, dye, natural oil, synthetic oil, wax, emulsion, magnetic material, dielectric property adjuster, and/or toughness improver.

Methods for forming the curable resin composition layer made from the curable resin composition on the support may include, but are not limited to, applying, spraying, or flow-casting the curable resin composition, which further contains an organic solvent if desired, to the support, and drying the curable resin composition on the support.

The curable resin composition in the curable resin composition layer may be uncured or tack dry. "Uncured" means that the whole curable resin is substantially dissoluble when immersed in a solvent that can dissolve the curable resin used to prepare the curable resin composition. "Tack dry" means that the curable resin composition is nearly cured and will be fully cured by further heating. "Tack dry" preferably means that the curable resin used to prepare the curable resin composition is partly dissoluble (7% or more by mass is dissoluble, with the composition partly remaining undissolved) in a solvent that can dissolve the curable resin, or means that the curable resin composition layer immersed in the solvent for 24 hours has a volume as large as or larger than 200% of a volume before the immersion.

Formation of conductor layer

The conductor layer is a layer including wiring made of a copper or metal conductor. The conductor layer may include circuits, without limitation to their wiring layouts, configurations, and thicknesses.

The conductor layer is formed on the electrical insulating layer by a known technique, for example, plating. After the support is detached from the electrical insulating layer, if necessary, the conductor layer is formed on the electrical insulating layer by, for example, a full-additive process or semi-additive process.

If the layered structure has the via holes before the conductor layer is formed thereon, conductors are formed in the via holes simultaneously when the conductor layer is formed so as to electrically interconnect the conductor layers through vias. The conductor layer is formed on the electrical insulating layer after the electrical insulating layer is subjected to a known surface treatment to improve adhesion between the conductor layer and the electrical insulating layer.

Via forming step

In an example of the manufacturing method for a multilayer printed wiring board according to the present invention, the via hole formation and the smear removal, which are included in the via forming step, may occur between timings of forming the electrical insulating layer and forming the conductor layer. Specifically, via hole formation and smear removal are targeted for a substrate obtained by alternately forming the electrical insulating layer n times in total (n is an integral number greater than or equal to 1) and the conductor layer n-1 times in total on the inner substrate. The conductors are formed in the holes in the via forming step simultaneously when the nth conductor layer is formed.

Formation of holes for vias

The via holes may be formed by such a known technique as laser machining, drilling, or plasma etching. Among these means, laser machining using a carbon dioxide laser, excimer laser, UV laser, or UV-YAG laser is preferably employed. This is because the laser machining may allow minute holes to be formed without degrading properties of the electrical insulating layer.

As described earlier, the via holes may be formed before the support is detached from the electrical insulating layer (that is, with the support still attached to the electrical insulating layer where the holes will be formed). The via holes formed by the laser machining before the support is detached from the electrical insulating layer may be smaller in diameter and may have a higher open area ratio (bottom diameter/opening diameter).

The holes may have a depth that allows desired conductor layers to be interconnected. Further, the holes may have an optional size.

Smear removal

In an example of the manufacturing method for a multilayer printed wiring board according to the present invention, the smear generated during the formation of the via holes is removed by the desmear processing method according to the present invention hereinafter described in detail. As described earlier, the smear may be removed before the support is detached from the electrical insulating layer (that is, with the support still attached to the electrical insulating layer where the holes are formed).

Desmear processing method

In the desmear processing method according to the present invention, a first desmear processing step and a second desmear processing step may be applied to the substrate having the via holes formed as described so far. The first desmear processing step is a step of dissolving or decomposing part of the smear. The second desmear processing step is a step of subjecting the substrate to an ultrasonic treatment subsequent to the first desmear processing step. The desmear processing method according to the present invention further includes, during the ultrasonic treatment in the second desmear processing step, at least one of: changing an ultrasonic frequency; and moving the substrate and the ultrasonic oscillation source relative to each other in two or more directions. The desmear processing method according to the present invention removes the smear through the first and second desmear processing steps. This method, therefore, may allow thorough removal of the smear, while substantially preventing the substrate surface having the holes (surface of the electrical insulating layer) from being roughened.

An assumption - a clear, logical explanation unavailable to date - is given below on how the first and second desmear processing steps combined may allow thorough removal of the smear without having to roughen the surface of the electrical insulating layer. That is, only partial removal of the smear in the first desmear processing step may prevent the substrate's target surface from being roughened, unlike having the whole smear dissolved or decomposed at once. While a conventional ultrasonic treatment alone may be insufficient for removal of any remaining portion of the smear, change of the ultrasonic frequency and/or relative movement of the ultrasonic oscillation source and the substrate in two or more directions, when combined with the ultrasonic treatment, may improve effectiveness of the ultrasonic treatment on the whole substrate. This may accomplish thorough removal of any remaining portion of the smear, in contrast to subjecting the substrate solely to the ultrasonic treatment.

First desmear processing step

The first desmear processing step removes part of the smear using a known desmear processing method by which the smear is removed from the substrate by dissolution or decomposition. Specifically, the first desmear processing step may remove part of the smear by at least one method selected from the group consisting of: making the substrate contact a solution containing an oxidizable compound such as permanganate (desmear solution); irradiating the substrate with plasma; and irradiating the substrate with light, for example, ultraviolet light. Making the substrate contact the desmear solution, particularly, a permanganate-containing desmear solution is preferable in view of low-cost and efficient removal of the smear.

Non-limiting examples of how to make the substrate contact the desmear solution may include known techniques such as immersing the substrate in the desmear solution, spreading the desmear solution on the substrate, and filling the substrate holes with the desmear solution. When immersing the substrate in the desmear solution is chosen and exercised, the substrate may be immersed and rocked in the desmear solution to more efficiently remove the smear. When the desmear solution is used, the substrate may be subjected to a known treatment, for example, a swelling treatment or neutralizing reduction, before or after the contact with the desmear solution.

A device used to irradiate the substrate with plasma may be, but is not limited to, a vacuum plasma device or an atmospheric pressure plasma device. Examples of the plasma may include known plasmas, for example, plasma of a reactive gas such as oxygen plasma, plasma of an inactive gas such as argon plasma or helium plasma, and plasma of a mixture of these gases. To prevent the substrate's target surface from being roughened in the first desmear processing step, preferably, the substrate may be irradiated with plasma before the support is detached from the electric insulating layer. A device used to irradiate the substrate with light may be, but is not limited to, an ultraviolet irradiation device. To prevent the target surface of the substrate from being roughened in the first desmear processing step, preferably, the substrate may be irradiated with ultraviolet light before the support is detached from the electric insulating layer.

Second desmear processing step

In the second desmear processing step subsequent to the first desmear processing step, the substrate immersed in a cleaning liquid, such as water, in an ultrasonic treatment tank is irradiated with ultrasonic waves to remove any residual smear left unremoved in the first desmear processing step. With ultrasonic waves being radiated on the substrate immersed in the cleaning liquid in the second desmear processing step, the ultrasonic frequency is changed and/or the ultrasonic oscillation source and the substrate are moved relative to each other in two or more directions to thoroughly remove the smear left unremoved. When the desmear solution is used in the first desmear processing step, the desmear solution left on the substrate may be removed prior to the second desmear processing step as conventionally done, for example, by washing away with water, or may be removed from the substrate by immersion in the cleaning solution during the second desmear processing step.

The ultrasonic waves radiated during the ultrasonic treatment preferably have a frequency more than or equal to 15 kHz and less than or equal to 200 kHz, or more preferably more than or equal to 20 kHz and less than or equal to 100 kHz. The ultrasonic frequency set to stay within the numerical ranges may allow effective removal of the smear, providing an improved desmearing effect. In the second desmear processing step, ultrasonic treatment time for the substrate is preferably more than or equal to 15 seconds, or and more preferably more than or equal to 30 seconds and less than or equal to 30 minutes. This is because the ultrasonic treatment time more than or equal to 15 seconds may be sufficient for effective removal of the smear, providing an improved desmearing effect. The ultrasonic treatment time less than or equal to 30 minutes may allow the first and second desmear processing steps to be consecutively performed to more efficiently remove the smear.

The desmear processing method according to the present invention performs the second desmear processing step after the smear is partly removed in the first desmear processing step. Then, this method, in the second desmear processing step, changes the ultrasonic frequency and/or moves the ultrasonic oscillation source and the substrate relative to each other in two or more directions. Therefore, even if plural substrates are subjected to the ultrasonic treatment at once in the second desmear processing step, this method may thoroughly remove the smear from all of the substrates.

Ultrasonic frequency change

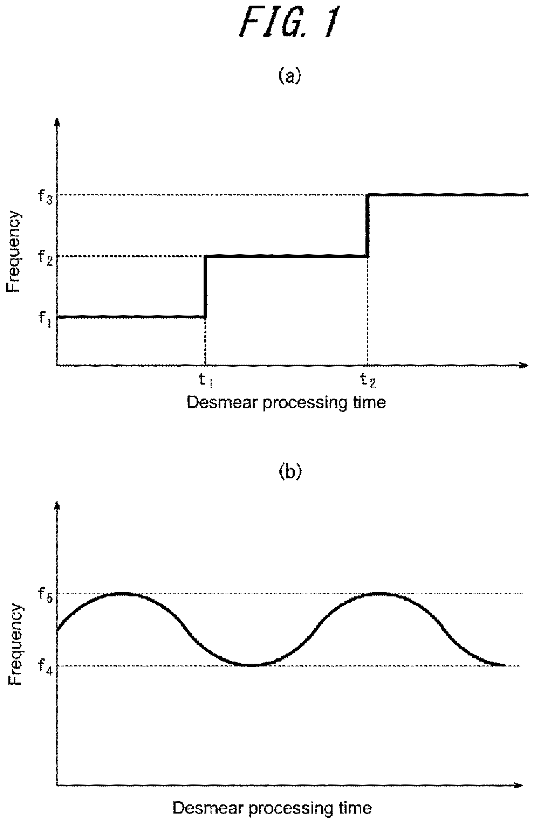

In the second desmear processing step, the ultrasonic frequency may be changed in stages (stepwise) as illustrated in FIG. 1A, or may be changed in succession as illustrated in FIG. 1B.

In FIG. 1A, the frequency is increased from $f_1$ to $f_2$ at time $t_1$ after the ultrasonic treatment has started, and is further increased from $f_2$ to $f_3$ at time $t_2$. Instead, the frequency may be decreased in stages or may be repeatedly increased and decreased in turns. The frequency may be changed an optional number of times.

While the ultrasonic frequency is changed in FIG. 1B between $f_4$ and $f_5$ in a sinusoidal shape, the frequency may be changed in an optional shape, for example, a linear shape or a zigzag shape.

To further improve the desmearing effect, the ultrasonic frequency may be changed in the second desmear processing step by 2 kHz or more and 80 kHz or less.

Relative movement of ultrasonic oscillation source and substrate in two or more directions

The relative movement of the ultrasonic oscillation source and the substrate in two or more directions in the second desmear processing step may occur by moving at least one of the substrate and the oscillation source relative to the other. For easier handleability in the relative movement of the ultrasonic oscillation source and the substrate, the substrate alone is preferably moved by a device equipped with a robot arm or a rocking mechanism, with the oscillation source being fixed at a position.

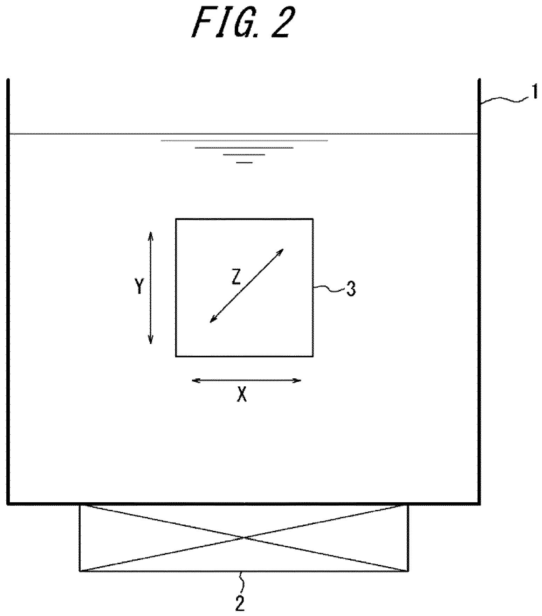

Any optional directions may be chosen for two or more directions in which the oscillation source and the substrate are moved relative to each other. In an ultrasonic treatment tank 1 having an ultrasonic oscillation source 2 at its bottom, as illustrated in FIG. 2, the oscillation source 2 and a substrate 3 may be moved relative to each other in a direction X parallel to the bottom surface of the ultrasonic treatment tank 1 and short sides of the substrate 3 (lateral direction in FIG. 2), a direction parallel to the bottom surface of the ultrasonic treatment tank 1 and the thickness direction of the substrate 3 (direction orthogonal to the paper in FIG. 1), a direction Y orthogonal to the bottom surface of the ultrasonic treatment tank 1 (vertical direction in FIG. 2), a direction Z inclined to the directions X and Y, or these directions optionally combined.

For easier handleability, the relative movement may occur by moving (rocking) the substrate plural times in directions that differ through 180 degrees (two or more cycles of forward and backward movements). To obtain an improved desmearing effect, the substrate is preferably rocked in directions toward and away from the oscillation source (vertical direction in FIG. 2).

To obtain an improved desmearing effect, a distance D of the relative movement of the ultrasonic oscillation source and the substrate preferably satisfies the relational expression (1) below.

$$\{\text{sonic speed/(ultrasonic frequency} \times 2)\}/4 \leq D \leq 150 \times \{\text{sonic speed/(ultrasonic frequency} \times 2)\} \ldots (1)$$

The distance D more preferably satisfies the relational expression (2) below.

$$\{\text{sonic speed/(ultrasonic frequency} \times 2)\}/3 \leq D \leq 100 \times \{\text{sonic speed/(ultrasonic frequency} \times 2)\} \ldots (2)$$

The distance D greater than or equal to one-fourth of {sonic speed/(ultrasonic frequency $\times$ 2)} may allow the whole substrate to be more effectively ultrasonically treated, leading to a further improved desmearing effect. Assuming that the distance D is greater than 150 times of {sonic speed/(ultrasonic frequency $\times$ 2)}, moving these devices may be complex and difficult, and a larger ultrasonic treatment tank may be necessary.

The smear-removed substrate obtained by the desmear processing method described so far may be washed and dried, if necessary, by known washing and drying methods, and then used to manufacture a multilayer printed wiring board.

WORKING EXAMPLES

Non-limiting working examples of the present invention are hereinafter described. In the description below, "%" and "parts" used in quantity both represent content by mass unless indicated otherwise.

In the working examples and comparative examples, loss tangents of cured materials, substrate desmearing effects, and degrees of desmearing-caused surface roughness were evaluated as described below.

Loss tangent

Small pieces were cut out in the width of 2.0 mm, length of 80 mm, and thickness of 40 $\mu$m from a filmy cured material which was obtained from a curable resin composition used to form an electrical insulating layer. Then, loss tangents of the respective pieces were measured by cavity resonator perturbation, dielectric constant measuring equipment.

Desmearing effect

After the via holes were formed, the holes at five positions; center, upper, lower, right, and left positions, on front and back surfaces of the desmearing-finished substrates (total ten positions) were observed by an electron microscope (1000 magnifying power), and whether the holes had any residual resin was evaluated under the following criteria.
Among all of the holes observed,

A: No residual resin at periphery or center of the bottoms of any holes observed
B: Residual resin at periphery and/or center of the bottoms of 1 to 3 holes, no residual resin in the other holes
C: Residual resin at periphery and/or center of the bottoms of 4 to 7 holes, no residual resin in the other holes
D: Residual resin at periphery and/or center of the bottoms of 8 or more holes Surface roughness

After the via holes were formed, degrees of surface roughness (arithmetic average roughness Ra) at five positions of an electrical insulating layer-exposed part (range of measurement: 91 $\mu$m$\times$120 $\mu$m) in each of the desmearing-finished subsrates were measured by a surface measuring equipment (WYKO NT1100, supplied by Veeco Instruments Inc.). The largest values of surface roughness obtained from the measurement were evaluated under the following criteria. The largest values of surface roughness with smaller numerals indicate less roughness of the substrate surfaces.

A: Arithmetic average roughness Ra < 100 nm
B: Arithmetic average roughness Ra $\geq$ 100 nm and < 200 nm
C: Arithmetic average roughness Ra $\geq$ 200 nm

Working example 1

Synthesis of alicyclic olefin polymer

First polymerization stage: 35 mol pts. of 5-ethylidene-bicyclo[2.2.1]hept-2-ene, 9 mol pts. of 1-hexene, 340 mol pts. of anisole, and 0.005 mol pts. of a ruthenium-based polymerization catalyst; 4-acetoxybenzylidene (dichloro) (4.5-dibromo-1,3-dimesityl-4-imidazoline-2-ylidene)(tricyclohexylphosphine) ruthenium (C1063, supplied by Wako Pure Chemical Industries, Ltd.), were put in a nitrogen-substituted, pressure-resistant glass reactor, and then stirred and polymerized at 80°C for 30 minutes. As a result, a norbornene-based, ring-opening polymer solution was obtained.
Second polymerization stage: 45 mol pts. of tetracyclo [9.2.1.0$^{2,10}$.0$^{3,8}$] tetradeca-3,5,7,12-tetraene, 20 mol pts. of bicyclo[2.2.1]hept-2-ene-5,6-dicarboxylic acid anhydride, and 250 mol pts. of anisole, and 0.01 mol pts. of C1063 were added to the solution obtained in the first polymerization stage, and then stirred and polymerized at 80°C for 1.5 hours. As a result, a norbornene-based, ring-opening polymer solution was obtained. Gas chromatography conducted on the polymer solution confirmed that this solution substantially contained no residual monomeric substance and had the degree of polymerization greater than or equal to 99%.
Then, the obtained ring-opening polymer solution was put in a nitrogen-substituted, agitator-attached autoclave, and 0.03 mol pts. of C1063 was added to this solution. The resulting solution was stirred at 150°C under the hydrogen pressure of 7 MPa for five hours to induce a hydrogen reaction. As a result, an alicyclic olefin polymer (hydrogenated norbornene-based, ring-opening polymer) solution was obtained. The alicyclic olefin polymer had the weight average molecular weight of 60,000, number-average molecular weight of 30,000, and molecular weight distribution of 2. Further, the alicyclic olefin polymer had the degree of hydrogenation of 95%, and contained 20 mol% of recurring units of carboxylic acid anhydride groups. The alicyclic olefin polymer solution had the solid content concentration of 22%.

Preparation of first thermosetting resin composition

First, 15 pts. of a multivalent epoxy compound having a biphenyl structure; a biphenyldimethylene skeleton novolak epoxy resin (trade name "NC-3000L", supplied by Nippon Kayaku Co., Ltd., 269 in epoxy equivalent), 20 pts. of an activated ester compound (trade name "EPICLON HPC-8000-65T", a toluene solution containing 65% of non-volatile matter, supplied by DIC Corporation, 223 in active ester group equivalent) (13 pts. in terms of an activated ester compound), 87 pts. of an organic filler; silica (trade name "SC25OO-SXJ", supplied by Admatechs Corporation Limited), 0.2 pts. of an antioxidant; a hindered phenol-based antioxidant (trade name "Irganox (registered trademark) 3114", supplied by BASF Corporation), and 24 pts. of anisole were mixed and stirred with a planetary stirrer for 3 minutes. Further, 2 pts. of a solution obtained by dissolving 20% of a curing accelerator; 2-phenylimidazole in ethanol (0.4 pts. in terms of 2-phenylimidazole) was added to the mixture and stirred with the planetary stirrer for 10 minutes. As a result, a first thermosetting resin composition varnish was obtained. The varnish contained 75% of the filler in terms of a solid content.

Preparation of second thermosetting resin composition

Anisole was mixed with the following materials so that the solid content concentration was 16%, 454 pts. of the alicyclic olefin polymer solution (100 pts. in terms of an alicyclic olefin compound), 36 pts. of a curing agent; a multivalent epoxy compound with dicyclopentadiene skeleton (trade name: "EPICLON HP7200L", supplied by DIC Corporation, "EPICLON" is a registered trademark), 24.5 pts. of an inorganic filler; silica (trade name "ADMOFINE SO-C1", supplied by Admatechs Corporation Limited, average particle size of 0.25 $\mu$m, "ADMOFINE" is a registered trademark), 1 pt. of an antioxidant; tris(3,5-di-t-butyl-4-hydroxybenzyl)-isocyanurate (trade name: "IRGANOX (registered trademark) 3114", supplied by BASF Corporation), 0.5 pts. of an ultraviolet absorbent; 2-[2-hydroxy-3,5-bis($\alpha$,$\alpha$-dimetylbenzyl)phenyl]-2H-benzotriazole, and 0.5 pts. of a curing accelerator; 1-benzyl-2-phenylimidazole. As a result, a second thermosetting resin composition varnish was obtained. The varnish contained 15% of the filler in terms of a solid content.

Preparation of support-attached curable resin composition layer

The second thermosetting resin composition varnish obtained above was spread with a wire bar on a polyethylene terephthalate film having a release layer formed thereon (support, thickness of 38 $\mu$m) and dried at 80°C for 5 minutes in a nitrogen atmosphere to form on the support a second resin layer having the thickness of 3 $\mu$m made from the uncured second thermosetting resin composition (plated layer).

The first thermosetting resin composition varnish was spread with a doctor blade and an autofilm applicator on the second resin layer and dried in a nitrogen atmosphere at 80°C for 5 minutes to obtain a 40 $\mu$m-thick, support-attached curable resin composition layer including the second resin layer and a first resin layer (adhesive layer). The support-attached curable resin composition layer includes a support and a curable resin composition layer including the second resin layer made from the second thermosetting resin composition and the first resin layer made from the first thermosetting resin composition.

Preparation of inner substrate

To obtain an inner substrate, a base substrate having copper-clad surfaces on both sides was used, which had the 450 mm-square shape (450 mm × 450 mm) and was 0.8 mm in thickness. The core of the base substrate was obtained by impregnating glass fiber with a varnish containing a glass filler and a non-halogen-containing epoxy compound, and a copper film in the thickness of 18 $\mu$m was bonded to the core. Then, a conductor layer having a surface microetched by organic acid was formed on the base substrate. The conductor layer had the thickness of 18 $\mu$m and the wiring width and inter-wiring distance of 50 $\mu$m. Thus, the inner substrate was prepared.

Preparation of substrate and filmy cured material

First, 430 mm-square pieces were cut out from the support-attached curable resin composition layer obtained earlier and adhered to both surfaces of the inner substrate, with the support still being attached, so that surfaces of the pieces on their composition-layer sides were directed inward. A vacuum laminator equipped with upper and lower heat-resistant rubber pressing plates was used for thermocompression bonding. Subsequent to pressure reduction to 200 Pa, the pieces were bonded to the inner substrate by thermocompression at 110°C and under the pressure of 0.1 MPa for 60 seconds to firmly bond the pieces of the support-attached curable resin composition layer to the inner substrate. The resulting inner substrate was left at rest at room temperature for 30 minutes and then heated in atmosphere at 180°C for 30 minutes to cure the bonded pieces of the support-attached curable resin composition layer. As a result, a substrate was obtained in which cured resin layers (electrical insulating layers) were formed on the inner substrate.

The support-attached curable resin composition layer was stacked on a copper foil in the thickness of 10 $\mu$m, with the support still being attached, so that the curable resin composition layer was directed inward (copper foil side). Again, the vacuum laminator equipped with upper and lower heat-resistant rubber pressing plates was used for thermocompression bonding. Subsequent to pressure reduction to 0.8 hPa, the copper foil and the support-attached curable resin composition layer were bonded by thermocompression at 110°C under the pressure 0.1 MPa for 60 seconds. The resulting laminate was left at rest at room temperature for 30 minutes and heated in atmosphere at 180°C for 30 minutes, and then, heated again after the support was removed at 190°C for 90 minutes to cure the curable resin composition layer. The copper foil-attached, cured resin layer was cut out from the laminate, and the copper foil was dissolved in 1 mol/L of an ammonium persulfate-containing aqueous solution to obtain a filmy cured material. The loss tangent of the obtained filmy cured material was evaluated under the criteria described earlier, which was 0.004.

Formation of via holes

The cured resin layers (electrical insulating layera) formed on both surfaces of the inner substrate were, with the support still being attached, irradiated with $CO_2$ laser from the support side using a $CO_2$ laser machining device under the conditions of mask diameter of 2.5 mm, output of 1.1W, and two cycles of burst shots. As a result, holes having the diameter of 70 $\mu$m were formed in the electrical insulating layers.

First desmear processing step

After the support was detached from the substrate having the holes formed therein, the substrate was rockingly immersed for 10 minutes in a swelling solution (aqueous solution at 60°C containing 500 mL/L of "Swelling Dip Securiganth P" (supplied by ADTEC, "Securiganth" is a registered trademark) and 3 g/L of sodium hydroxide) to be subjected to swelling treatment, and then washed with water.
Then, a desmear solution was prepared by adding sodium hydroxide to 640 mL/L of a sodium permanganate-containing aqueous solution (trade name: "Concentrate Compact CP", supplied by ADTEC) so that the concentration of sodium hydroxide was 40 g/L. The substrate was immersed and rocked for 20 minutes in the desmear solution at 80°C to remove part of the smear (residual resin), and then further washed with water.
The substrate was further immersed for 5 minutes in a hydroxylamine sulfate-containing aqueous solution at 40°C (aqueous solution containing 100 mL/L of "Reduction Securiganth P500" (supplied by ADTEC, "Securiganth" is a registered trademark) and 35 mL/L of sulfuric acid) for neutralizing reduction, and then washed with water.

Second desmear processing step

An ultrasonic treatment tank equipped with an ultrasonic oscillator (output: 600W) at its bottom was used. After the first desmear processing step, the substrate was put in the ultrasonic treatment tank filled with pure water and rocked perpendicularly to the bottom surface of the ultrasonic treatment tank (vertically rocked), with ultrasonic waves at the frequency of 28 kHz being applied to the substrate. The substrate, while being vertically rocked in cycles of 0.15 min. per cycle within the distance of 8 cm (distance of three-fold of (sonic speed/(ultrasonic frequency×2), was subjected to the ultrasonic treatment for 15 minutes to further remove the smear.
The desmearing effect and surface roughness of the ultrasonically treated substrate were evaluated. Table 1 shows an obtained evaluation result.

Working example 2

A substrate and a filmy cured material were prepared, via holes were formed, and the first and second desmear processing steps were performed similarly to the working example 1, except that the substrate, during the second desmear processing step, was rocked in a horizontal direction parallel to the bottom surface of the ultrasonic treatment tank (distance: 10 cm, cycle: 0.15 min., ultrasonic treatment time: 15 min.) The resulting substrate was evaluated as in working example 1. Table 1 shows an obtained evaluation result.

Working example 3

A substrate and a filmy cured material were prepared, via holes were formed, and the first and second desmear processing steps were performed similarly to the working example 1, except that the substrate was reciprocated perpendicularly to the bottom surface of the ultrasonic treatment tank (distance: 8 cm, cycle: 0.15 min.) and then reciprocated in the horizontal direction (distance: 10 cm, cycle: 0.15 min.), repeatedly, during the second desmear processing step (that is, the substrate was rocked vertically and horizontally in turns, repeatedly). The resulting substrate was evaluated as in working example 1. Table 1 shows an obtained evaluation result.

Working example 4

A substrate and a filmy cured material were prepared, via holes were formed, and the first and second desmear processing steps were performed similarly to the working example 1, except that the ultrasonic frequency was changed in stages during the second desmear processing step, without rocking movement of the substrate in the ultrasonic treatment tank (that is, with the substrate being fixed at a position). The ultrasonic frequency continued to be changed in cycles of 28 kHz (10 seconds), 50 kHz (10 seconds), and 100 kHz (10 seconds) per cycle for 15 minutes until the ultrasonic treatment was over. The resulting substrate was evaluated as in working example 1. Table 1 shows an obtained evaluation result.

Working example 5

A substrate and a filmy cured material were prepared, via holes were formed, and the first and second desmear processing steps were performed similarly to the working example 1, except that the ultrasonic frequency was changed in succession between 27 kHz and 29 kHz during the second desmear processing step, without rocking movement of the substrate in the ultrasonic treatment tank (that is, with the substrate being fixed at a position). The resulting substrate was evaluated as in working example 1. Table 1 shows an obtained evaluation result.

Working example 6

A substrate and a filmy cured material were prepared, via holes were formed, and the first and second desmear processing steps were performed similarly to the working example 1, except that the holes of the substrate with the support still attached thereto were irradiated with plasma to remove part of the smear during the first desmear processing step, instead of using the desmear solution. A plasma generator (trade name: "NM-FP1A", supplied by Panasonic Factory Solutions Co., Ltd.) was used to irradiate the substrate with plasma from the support side under the conditions of irradiation time of 20 min., output of 500W, gas pressure of 20 Pa, and room temperature, in an $O_2$ gas atmosphere. The resulting substrate was evaluated as in the working example 1. Table 1 shows an obtained evaluation result.

Working example 7

A substrate and a filmy cured material were prepared, via holes were formed, and the first and second desmear processing steps were performed similarly to working example 1, except that the holes of the substrate with the support still attached thereto were irradiated with ultraviolet light to remove part of the smear during the first desmear processing step, instead of using the desmear solution. An ultraviolet irradiation device equipped with a xenon excimer lamp was used to irradiate the substrate with ultraviolet light from the support side under the conditions of luminance of 40W/cm$^2$, light source-substrate distance of 3 mm, irradiation time of 60 min., and room temperature. The resulting substrate was evaluated as in working example 1. Table 1 shows an obtained evaluation result.

Working example 8

A substrate and a filmy cured material were prepared, via holes were formed, and the first and second desmear processing steps were performed similarly to working example 1, except that a third thermosetting resin composition varnish prepared as described below was used instead of the first thermosetting resin composition varnish. The resulting substrate was evaluated as in working example 1. Table 1 shows an obtained evaluation result. The loss tangent of a cured material prepared by using the third thermosetting resin composition was 0.003.

Preparation of third thermosetting resin composition

First, 15 pts. of a multivalent epoxy compound having a biphenyl structure; a biphenyldimethylene skeleton novolak epoxy resin (trade name "NC-3000L", supplied by Nippon Kayaku Co., Ltd., 269 in epoxy equivalent), 20 pts. of a polyphenylene ether compound: a polyphenylene ether compound having styryl groups modified at both ends (trade name: "OPE-2St 1200", supplied by MITSUBISHI GAS CHEMICAL COMPANY, a reaction product of chloromethylstyrene and 2.2',3,3',5.5'-hexamethylbiphenyl-4,4'-diol·2,6-dimethylphenolpolycondensate, number-average molecular weight (MN) = 1200, 60% toluene solution, (12 pts. in terms of a polyphenylene ether compound), 23 pts. of an activated ester compound (trade name: "EPICLON HPC-8000-65T", a toluene solution containing 65% of non-volatile matter, supplied by DIC Corporation, 223 in active ester group equivalent, 15 pts. in terms of an activated ester compound), 130 pts. of an inorganic filler; silica (trade name "SC25OO-SXJ", supplied by Admatechs Corporation Limited), 0.1 pts. of an antioxidant; a hindered phenol-based antioxidant (trade name "Irganox" (registered trademark) 3114, BASF Corporation), and 25 pts. of anisole were mixed and stirred with a planetary stirrer for 3 minutes. The resulting material was further mixed with 2 pts. of a solution obtained by dissolving 20% of a curing agent; 2-phenylimidazole in ethanol (0.4 pts. in terms of 2-phenylimidazole), and 0.24 pts. of a solution obtained by dissolving 50% of a curing agent; dicumyl peroxide (trade name: "Perkadox BC-FF", supplied by Kayaku Akzo Corporation) in toluene (0.12 pts. in terms of dicumyl peroxide) and stirred with a planetary stirrer for 5 minutes. As a result, a third thermosetting resin composition varnish was obtained. The varnish contained 75% of the filler in terms of a solid content.

Working example 9

A substrate and a filmy cured material were prepared, via holes were formed, and the first and second desmear processing steps were performed similarly to the working example 1, except that the ultrasonic frequency was 430 kHz during the second desmear processing step. The resulting substrate was evaluated as in the working example 1. Table 1 shows an obtained evaluation result.

Comparative example 1

A substrate and a filmy cured material were prepared, via holes were formed, and the first and second desmear processing steps were performed similarly to working example 1, except that the substrate in the ultrasonic treatment tank was not rocked during the second desmear processing step. The resulting substrate was evaluated as in working example 1. Table 1 shows an obtained evaluation result.

Comparative example 2

A substrate and a filmy cured material were prepared, via holes were formed, and the first desmear processing step was performed similarly to sworking example 1, except that the second desmear processing step was not performed. The resulting substrate was evaluated as in working example 1. Table 1 shows an obtained evaluation result.

Comparative example 3

A substrate and a filmy cured material were prepared, via holes were formed, and the first desmear processing step was performed similarly to working example 1, except that the substrate was immersed and rocked for 60 minutes in the desmear solution during the first desmear processing step, and the second desmear processing step was not performed. The resulting substrate was evaluated as in working example 1. Table 1 shows an obtained evaluation result.

Table 1

| | | Working Example1 | Working Example2 | Working Example3 | Working Example4 | Working Example5 | Working Example 6 | Working Example7 | Working Example8 | Working Example9 | Comparative Example1 | Comparative Example2 | Comparative Example3 |
|---|---|---|---|---|---|---|---|---|---|---|---|---|---|
| First desmear processing step | Desmearing | Desmear solution | Desmear solution | Desmear solution | Desmear solution | Desmear solution | Plasma | Ultraviolet light | Desmear solution | Desmear solution | Desmear solution | Desmear solution | Desmear solution |
| | Desmear processing time (min.) | 20 | 20 | 20 | 20 | 20 | 20 | 60 | 20 | 20 | 20 | 20 | 60 |
| Second desmear processing step | Ultrasonic output (W) | 600 | 600 | 600 | 600 | 600 | 600 | 600 | 600 | 600 | 600 | - | - |
| | Frequency (kHz) | 28 | 28 | 28 | 28,50,100 | 27 to 29 | 28 | 28 | 28 | 430 | 28 | - | - |
| | Rocking | Vertical | Horizontal | Vertical and horizontal | - | - | Vertical | Vertical | Vertical | Vertical | - | - | - |
| | Desmear processing time (min.) | 15 | 15 | 15 | 15 | 15 | 15 | 15 | 15 | 15 | 15 | - | - |
| Desmearing effect | | A | A | A | A | A | A | A | A | B | C | D | B |
| Surface roughness | | A | A | A | A | A | A | A | A | A | A | A | C |

Table 1 reveals that the smear was adequately removed, with a substantially reduced roughness of the substrate surfaces, in any of working examples 1 to 9 in which the second desmear processing step included at least one of the ultrasonic frequency change and relative movement of the substrate and the ultrasonic oscillation source in two or more directions. On the other hand, removal of the smear was insufficient in comparative examples 1 and 2 in which the second desmear processing step included neither of the ultrasonic frequency change nor relative movement of the substrate and the ultrasonic oscillation source in two or more directions. In comparative example 3 in which the first desmear processing step carried on over an extended time, the substrate's surface was roughened although the smear was removed to a certain extent.

INDUSTRIAL APPLICABILITY

The desmear processing method according to the present invention may thoroughly remove smear, while substantially preventing a target surface of a substrate from being roughened. The manufacturing method for a multilayer printed wiring board according to the present invention may thoroughly remove smear and successfully manufacture a high-performance multilayer printed wiring board.

REFERENCE SIGNS LIST

1    Ultrasonic treatment tank
2    Ultrasonic oscillation source
3    Substrate

**Claims**

1. A desmear processing method for removing smear from a substrate having holes formed therein, comprising:

   a first desmear processing step of dissolving or decomposing part of the smear; and
   a second desmear processing step of subjecting the substrate to an ultrasonic treatment subsequent to the first desmear processing step,
   the second desmear processing step comprising, during the ultrasonic treatment, at least one of: changing an ultrasonic frequency; and moving the substrate and an ultrasonic oscillation source relative to each other in two or more directions.

2. The desmear processing method according to claim 1, wherein ultrasonic waves radiated during the ultrasonic treatment have a frequency more than or equal to 15 kHz and less than or equal to 200 kHz.

3. The desmear processing method according to claim 1 or 2, wherein a distance D of the relative movement of the substrate and the ultrasonic oscillation source satisfies the relational expression,

$$\{sonic\ speed/(ultrasonic\ frequency \times 2)\}/4 \leq D \leq 150 \times \{sonic\ speed/(ultrasonic\ frequency \times 2)\} \ ... \ (1)$$

4. The desmear processing method according to any one of claims 1 to 3, wherein the smear is dissolved or decomposed by at least one means selected from the group consisting of a desmear solution, plasma, and light.

5. The desmear processing method according to claim 4, wherein:

   in the first desmear processing step, the desmear solution is used to dissolve or decompose the smear, and
   the desmear solution comprises permanganate.

6. The desmear processing method according to any one of claims 1 to 5, wherein:

   the substrate comprises an electrical insulating layer having the holes, and
   the electrical insulating layer comprises a cured material having a loss tangent less than or equal to 0.005 at the frequency of 5 GHz.

7.  The desmear processing method according to any one of claims 1 to 6, wherein:

the substrate comprises an electrical insulating layer having the holes, and
a curable resin composition comprising an epoxy resin and an activated ester compound is used to form the electrical insulating layer.

8.  The desmear processing method according to claim 7, wherein the curable resin composition further comprises a polyphenylene ether compound.

9.  The desmear processing method according to any one of claims 1 to 8, wherein:

the substrate comprises an electrical insulating layer having the holes, and
the electrical insulating layer comprises a layer containing 50% or more by mass of an inorganic filler.

10.  The desmear processing method according to any one of claims 1 to 9, wherein:

the substrate comprises a support and an electrical insulating layer having the holes, and
the support is formed on a surface of the electrical insulating layer to be a part of the surface.

11.  The desmear processing method according to claim 10, wherein the support has ultraviolet absorptivity.

12.  A manufacturing method for a multilayer printed wiring board having vias, comprising steps of:

forming holes for vias in a substrate having electrical insulating layers and conductor layers that are alternately stacked; and
removing smear generated during the formation of the holes using the desmear processing method according to any one of claims 1 to 11.

# FIG. 1

(a)

(b)

# FIG. 2

**INTERNATIONAL SEARCH REPORT**

| International application No. |
| --- |
| PCT/JP2015/005867 |

| A. CLASSIFICATION OF SUBJECT MATTER |
| --- |
| *H05K3/42*(2006.01)i, *H05K1/03*(2006.01)i |

According to International Patent Classification (IPC) or to both national classification and IPC

| B. FIELDS SEARCHED |
| --- |
| Minimum documentation searched (classification system followed by classification symbols)<br>H05K3/42, H05K1/03 |

Documentation searched other than minimum documentation to the extent that such documents are included in the fields searched
Jitsuyo Shinan Koho        1922-1996   Jitsuyo Shinan Toroku Koho   1996-2016
Kokai Jitsuyo Shinan Koho   1971-2016   Toroku Jitsuyo Shinan Koho    1994-2016

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | JP 2003-338679 A (SPC Electronics Corp.),<br>28 November 2003 (28.11.2003),<br>claims 12, 14, 17, 18; paragraphs [0015] to<br>[0017], [0020]; fig. 1, 2<br>(Family: none) | 1-5,12<br>6-11 |
| Y | JP 2011-256300 A (Ajinomoto Co., Inc.),<br>22 December 2011 (22.12.2011),<br>claims 1, 4, 7, 8, 11; paragraph [0033]<br>(Family: none) | 6-11 |
| Y | JP 2001-251054 A (Ibiden Co., Ltd.),<br>14 September 2001 (14.09.2001),<br>claim 1<br>(Family: none) | 10-11 |

☐ Further documents are listed in the continuation of Box C.      ☐ See patent family annex.

| * Special categories of cited documents: | "T" later document published after the international filing date or priority |
| --- | --- |
| "A" document defining the general state of the art which is not considered  to be of particular relevance | date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>05 February 2016 (05.02.16) | Date of mailing of the international search report<br>16 February 2016 (16.02.16) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005327978 A

- WO 2014104154 A